# NEUE EUROPÄISCHE PATENTSCHRIFT

(11) **EP 0 493 317 B2**
(45) Veröffentlichungstag und Bekanntmachung des Hinweises auf die Entscheidung über den Einspruch: **10.01.2001**
(45) Hinweis auf die Patenterteilung: 20.05.1998
(21) Anmeldenummer: 91810957.0
(22) Anmeldetag: 09.12.1991
(51) Int. Cl.: G03F 7/032, G03F 7/26, C08F 20/10

(54) **Strahlungsempfindliche Zusammensetzung auf Basis von Wasser als Lösungsmittel**
Radiosensitive composition on basis of water as solvent
Composition radiosensible à base de l'eau comme solvant

(30) Priorität: 18.12.1990 CH 401090
(43) Veröffentlichungstag der Anmeldung: 01.07.1992
(73) Patentinhaber: Ciba Specialty Chemicals Holding Inc., 4057 Basel (CH)
(72) Erfinder: Salvin, Roger Pierre-Elie, Dr., W-7858 Weil am Rhein (DE); Schulthess, Adrian, Dr., CH-1734 Tentlingen (CH)

(56) Entgegenhaltungen:
- EP-A- 0 232 016
- Ullmanns Encyklopädie der techn. Chemie, Bd.19 (1981), S.11
- Proceedings International Conference on Organic Coatings Science and Technology, S. 197-209
- Polymer Paint Colour Journal, Bd. 175, Nr. 4141 (1985), S.254
- Römpp's Chemielexikon, 8. Aufl. (1983), S. 2326

## Beschreibung

Die Erfindung betrifft eine strahlungsempfindliche Zusammensetzung, ein Verfahren zu deren Herstellung, ein Verfahren zur Erzeugung einer Beschichtung mit Hilfe dieser Zusammensetzung und eine bevorzugte Verwendung der Zusammensetzung.

Strahlungsempfindliche Zusammensetzungen und ihr Einsatz als Photoresist, z. B. zur Herstellung von Lotstoppmasken (solder masks), sind seit langem bekannt. In der EP-B-0115354 sind solche Zusammensetzungen beschrieben. Sie enthalten ein polymeres Bindemittel, das freie Carboxylgruppen aufweist, z. B. ein entsprechendes Polyacrylat, radikalisch polymerisierbare Monomere wie (Meth)acrylate, Photoinitiatoren für deren Polymerisation, z. B. Benzophenon, und gegebenenfalls einen Härter, beispielsweise ein Melamin, mit dem das Bindemittel nach Belichtung und Entwicklung thermisch vemetzt werden kann. Aufgrund der freien Carboxylgruppen am Bindemittel können Beschichtungen aus den genannten Zusammensetzungen nach der Belichtung zwar mit wässerig-alkalischen Lösungen, z. B. 1%-iger Na₂CO₃-Lösung, entwickelt werden, jedoch sind die Bindemittel im allgemeinen unlöslich in Wasser. Die Zusammensetzungen müssen daher in organischer Lösung, beispielsweise in Methylenchlorid/Methanol, häufig auch in Methoxypropylacetat oder Butylglycolacetat gelöst, appliziert werden. Dies ist im Hinblick auf die Umwelt unerwünscht und macht beispielsweise auch den Einsatz explosionsgeschützter Apparaturen erforderlich.

Es wurden auch schon strahlungsempfindliche Zusammensetzungen, u. a. zur Verwendung als Lötstoppresist beschrieben, die die Verwendung organischer Lösungsmittel bei der Applizierung vermeiden. So bildet den Gegenstand der internationalen Anmeldung WO 89/05476 eine solche strahlungsempfindliche Zusammensetzung auf Basis eines wässerig oder wässerig-alkalisch entwickelbaren fliessfähigen Bindemittels. Da dadurch die Zusammensetzungen selbst flüssig sind, ist zwar der Einsatz jeglichen Lösungsmittels zur Applizierung unnötig, es treten aber erhebliche andere Probleme auf. So wird ein zusätzlicher Härter nötig, der bereits beim milden Erhitzen zu einer Vernetzung und somit erst zur Verfestigung einer Beschichtung aus der Zusammensetzung auf einem Substrat führt. Die Vernetzung darf dabei aber nur so weit gehen, dass die Beschichtung mit Hilfe wässeriger oder wässerig-alkalischer Lösungen entwickelbar bleibt. Gemäss der Lehre dieser Anmeldung werden Epoxidharze für diese Vernetzung eingesetzt. Es wird allerdings darauf hingewiesen, dass diese Harze so reaktiv seien, dass es bereits während der Lagerungszeit zur Vernetzung komme, so dass die Verwendung der Zusammensetzungen in Form von Zweikomponentensystemen empfohlen wird. Ein weiterer Nachteil der genannten Zusammensetzungen ist ihre relativ hohe Viskosität, die sie für manche Applizierungsverfahren unbrauchbar macht, da beispielsweise die Auftragsmenge nicht genau genug gesteuert werden kann. Die viskosen Massen sind ausserdem nur schwierig zu entgasen, so dass es zu Gaseinschlüssen in der Beschichtung kommen kann, wobei bei den üblichen niedrigen Schichtdicken sogar Löcher in der Beschichtung auftreten können.

Ein weiterer Vorschlag, wie man den Einsatz organischer Lösungsmittel bei der Applizierung strahlungsempfindlicher Zusammensetzungen vermeiden kann, die dem oben geschilderten Typ ähnlich sind, ist aus der US-A-4,592,816 bekannt. Nach der dort beschriebenen Lehre kann beispielsweise ein freie Carboxylgruppen enthaltendes Polymer mit Natriumhydroxid umgesetzt und so in eine wasserlösliche Form überführt und mit einem Acrylatmonomeren und einem Photoinitiator in wässeriger Lösung appliziert werden. Die Applizierung erfolgt dabei mit Hilfe einer elektrophoretischen Abscheidung (Anaphorese), wobei eine wässerig-alkalisch entwickelbare Beschichtung erhalten wird. Die gemäss diesem US-Patent erhaltenen Beschichtungen werden unter anderem als Lötstopmaske vorgeschlagen und es wird darauf hingewiesen, dass neben der elektrophoretischen Abscheidung auch konventionelle Methoden in Frage kämen, um einen Film aus den geschilderten Zusammensetzungen auf den Substraten zu erzeugen. Bei Verwendung solcher konventionellen Methoden treten jedoch Probleme auf. So verbleiben in diesem Fall die Carbonsäuresalzreste selbstverständlich in der Beschichtung, während es bei einer Anaphorese zur Rückbildung der freien Polycarbonsäuren kommt. Die Carbonsäuresalzreste erhöhen aber die elektrische Leitfähigkeit der Beschichtung. Eine wesentliche Eigenschaft einer Lötstoppmaske, nämlich als Isolator zwischen den Leiterbahnen zu wirken, ist daher nicht mehr in ausreichendem Masse vorhanden. Ausserdem kann leicht Korrosion auftreten. Die elektrophoretische Abscheidungsmethode wiederum ist nur für Mischungen mit wenigen Bestandteilen anwendbar, wenn homogene Beschichtungen erhalten werden sollen. Es lässt sich nämlich kaum erreichen, dass alle Komponenten in einer Lösung gleich schnell und gleichsinnig im elektrischen Feld wandern.

In dem Aufsatz " Emulsified Photoresist for Printed Circuit Imaging" von Yeong-Cherng Chiou und Jonq-Min Liu (Materials Research Laboratories Bull. Res. Dev., Vol. 2, No. 2 (1988) pp. 13- 17) ist eine strahlungsempfindliche Zusammensetzung auf Basis von Wasser beschrieben, die als Bindemittel ein in Wasser emulgiertes Copolymeres aus Acrylaten, Styrol, Methacryl- und Acrylsäure enthält, neben photopolymerisierbaren (Meth)acrylatmonomeren und dafür geeigneten Photoinitiatoren. Die beschriebene Zusammensetzung ist speziell zur Herstellung von alkalisch entwickelbaren Trockenresists geeignet und enthält keine thermischen Härter.

Die vorliegende Erfindung betrifft nun eine strahlungsempfindliche Zusammensetzung auf Basis von Wasser als Lösungs- und/oder Dispersionsmittel für ihre Komponenten, die sich zur Herstellung einer Lötstoppresistbeschichtung eignet, die mit Hilfe einer wässerigen oder einer alkalisch-wässerigen Lösung entwickelbar ist, und die mindestens 30 Gew-% Wasser sowie zumindest die folgenden Bestandteile in den angegebenen Mengen enthält:
10 - 50 Gew.-% in Wasser lösliche, feste, vernetzbare, filmbildende Polymere als Bindemittel,
4 - 50 Gew.-% in Wasser lösliche und/oder dispergierbare photopolymerisierbare Acrylat- und/oder Methacrylatmonomere und/oder entsprechende Oligomere,
0,1 - 10 Gew.-% in Wasser lösliche und/oder dispergierbare Photoinitiatorverbindungen für die photopolymerisierbaren Acrylat- und/oder Methacrylatmonomere und/oder entsprechenden Oligomere sowie,
falls das Bindemittel nichtselbstvernetzende Polymere enthält,
2,5 - 40 Gew.-% in Wasser lösliche und/oder dispergierbare Vernetzungsmittel für die Bindemittelpolymere als thermischen Härter, ausgewählt aus der Gruppe: Epoxidharze, Melaminharze und blockierte Polyisocyanate.

Bevorzugt sind Zusammensetzungen, die die genannten Bestandteile in folgenden Mengenverhältnissen enthalten :
10 - 25 Gew.-% in Wasser lösliche, feste, vernetzbare, filmbildende Polymere als Bindemittel,
4 - 15 Gew.-% in Wasser lösliche und/oder dispergierbare photopolymerisierbare Acrylat- und/oder Methacrylatmonomere und/oder entsprechende Oligomere,
0,1 - 5 Gew.-% in Wasser lösliche und/oder dispergierbare Photoinitiatorverbindungen für die photopolymerisierbaren Acrylat- und/oder Methacrylatmonomere und/oder entsprechenden Oligomere sowie, falls das Bindemittel nichtselbstvemetzende Polymere enthält,
2,5 - 10 Gew.-% in Wasser lösliche und/oder dispergierbare Vemetzungsmittel für die Bindemittelpolymere als thermischen Härter, ausgewählt aus der Gruppe: Epoxidharze, Melaminharze und blockierte Polyisocyanate.

Besonders bevorzugt enthalten die erfindungsgemässen Gemische jedoch nur Vernetzungsmittel eines der genannten Typen, speziell nur ein einziges Vernetzungsmittel.

Neben den vorgenannten Komponenten können erfindungsgemässe Zusammensetzungen weitere Bestandteile enthalten, wie weiter unten noch genauer erläutert wird. Ausserdem enthalten die erfindungsgemässen Zusammensetzungen noch Wasser als im wesentlichen (i. w.) einziges Lösungs- und/oder Dispergiermittel. Allerdings können die Zusammensetzungen auch unwesentliche Anteile organischer Lösungsmittel enthalten, wenn beispielsweise für die Zusammensetzungen verwendete Komponenten in solchen Lösungsmitteln gelöst sind. Wasser bildet demnach bei den erfindungsgemässen Zusammensetzungen die Balance zu 100 Gew.-%. Der Wassergehalt der Zusammensetzungen wird dabei weitgehend von der gewünschten Viskosität für die Zusammensetzung bestimmt sein. Der bevorzugte Höchstgehalt an Wasser liegt bei etwa 70 Gew.-%.

Wesentlich für die Auswahl von Polymeren, die als Bindemittel für die erfindungsgemässen Zusammensetzungen geeignet sind, ist, dass die Polymere fest sind, während für alle anderen Komponenten der erfindungsgemässen Zusammensetzungen diese Einschränkung nicht obligatorisch ist. Unter "fest" soll in diesem Zusammenhang verstanden werden, dass der Erweichungspunkt der Polymere zumindest oberhalb Raumtemperatur liegt. Gut geeignet als Bindemittel sind beispielsweise Polymere, deren Erweichungspunkt oberhalb 60 °C liegt; besonders günstig ist ein Erweichungspunkt oberhalb 80 °C. Durch die Verwendung dieser festen, filmbildenden Polymere als Bindemittel wird die im oben genannten Stand der Technik beschriebene Verwendung von solchen Vernetzungsmitteln unnötig, die bereits bei den Temperaturen, die zur Entfernung des Lösungsmittels aus den Zusammensetzungen erforderlich sind, zu einer Vernetzung der Polymere führen, die zumindest so stark ist, dass sich eine mechanisch stabile Beschichtung aus der strahlungsempfindlichen Zusammensetzung bilden kann.

In Frage für die als Bindemittel fungierenden Polymere kommen besonders Polyvinylalkohol/Polyvinylacetat-Polymere bzw.-Copolymere, Maleinsäureanhydrid/Vinylether-Copolymere, Maleinsäureanhydrid/Styrol-Copolymere und Acrylsäure- und Methacrylsäure-Polymere bzw. -Copotymere sowie Carboxylgruppen enthaltende Acrylat- und Methacrylat-Polymere bzw. -Copolymere.

Bei den Maleinsäureanhydrid/Vinylether-Copolymeren, Maleinsäureanhydrid/Styrol-Copolymeren und Acrylsäure- und Methacrylsäure-Polymeren bzw. -Copolymeren sowie Carboxylgruppen enthaltende Acrylat- und Methacrylat-Polymeren bzw. -Copolymeren ist bevorzugt, wenn jeweils Carboxylgruppen (bzw. Anhydridgruppen) mit Ammoniak und/oder Aminen in einem solchen Ausmass umgesetzt sind, dass eine Wasserlöslichkeit der Polymere bzw. Copolymere gegeben ist, wobei die Amine so gewählt sind, dass sie sich zumindest bei Temperaturen, die zur thermischen Härtung der Polymere in der Zusammensetzung geeignet sind, i. w. aus einem aus der Zusammensetzung sich bildenden und/oder gebildeten Film verflüchtigen.

Die genannten Polymere sind dem Fachmann geläufig (siehe z. B. in ULLMANNS ENCYKLOPÄDIE DER TECHNISCHEN CHEMIE, 4. Aufl., Bd. 19, Verlag Chemie, Weinheim 1980) und sind teilweise auch kommerziell erhältlich. Ihr Molekulargewicht liegt bei Werten zwischen 2000 und 500000, bevorzugt über 10000.

Geeignete Maleinsäureanhydrid/Vinylether-Copolymere können z. B. Vinylmethylether als eine Etherkomponente enthalten und sind z. B. unter der Bezeichnung Gantrex® AN [GAF CORP.] erhältlich. Geeignete Maleinsäureanhydrid/ Styrol-Copolymere sind beispielsweise unter der Bezeichnung Scripset® Harze [MONSANTO] im Handel. Polyvinylalkohol wird bekanntlich durch mehr oder weniger starke Verseifung von Polyvinylacetat erhalten und ist gut wasserlöslich. Er kann beispielsweise unter der Bezeichnung Mowiol® [HOECHST] kommerziell bezogen werden, Polyvinylacetat z. B. unter der Bezeichnung Mowilith® [HOECHST]. Das Polyvinylacetat kann beispielsweise mit Anhydriden von Dicarbonsäuren, z. B. Maleinsäureanhydrid, copolymerisiert sein. Auch Copolymere von Polyvinylacetat mit Crotonsäure z. B. sind wasserlöslich und weisen gute Filmbildungseigenschaften auf.

Unter Acrylsäure- und Methacrylsäure-Polymeren bzw. -Copolymeren sowie Carboxylgruppen enthaltende Acrylat- und Methacrylat-Polymeren bzw. -Copolymeren sind sowohl die Homo- und Copolymeren der reinen Säuren zu verstehen als auch Copolymere der Säuren mit ihren Estern, bevorzugt den Alkylestern, und anderen Comonomeren wie z. B. Maleinsäure, Itaconsäure, deren Ester oder Styrol. Weitere geeignete Bindemittelpolymere dieses Typs sind in der EP-A-115354 genannt; verschiedene sind auch kommerziell erhältlich, z. B. unter Bezeichnungen wie Carboset® [GOODRICH], Joncryl® [JOHNSON] oder Surcol® [ALLIED COLLOIDS].

Die Säurezahl der Polymere [mg benötigtes KOH zur Neutralisation von 1 g Polymer], die also die Zahl freier Carboxylgruppen charakterisiert, sollte vor Umsetzung mit dem Ammoniak bzw. den Aminen mindestens 25 betragen, um gute Eigenschaften der Zusammensetzung im Hinblick auf Wasserlöslichkeit und auf Entwickelbarkeit in wässerig-alkalischen Lösungen zu gewährleisten. Noch besser und daher bevorzugt sind Säurezahlen über 60.

Die Umsetzung der Carboxylgruppen mit dem Ammoniak oder den Aminen führt im Sinne einer Neutralisationsreaktion zu entsprechenden Ammonium- bzw. Aminiumcarboxylaten. Diese relativ ionischen Carboxylatgruppen bewirken, dass die Bindemittelpolymere sich gut in Wasser lösen. Bei einer thermischen Behandlung einer solchen Zusammensetzung, wie es beispielsweise die Trocknung einer Beschichtung aus der Zusammensetzung oder die thermische Härtung einer solchen Beschichtungen darstellt, können sich hingegen die Ammonium- bzw. Aminiumcarboxylatgruppen wieder zersetzen, und sich die Basen verflüchtigen. Eine Beschichtung mit freien Carboxylgruppen ist das Ergebnis, die eine gute Löslichkeit in wässerigen alkalischen Lösungen aufweist.

Die als Bindemittel geeigneten Polymere müssen vernetzbar sein. Einmal kann es sich daher um selbstvernetzende Polymere handeln. Diese enthalten bekanntermassen Strukturelemente, die allein unter dem Einfluss von Wärme oder auch aktinischer Strahlung und ohne den Zusatz spezieller Substanzen als Härter eine Vernetzungsreaktion eingehen. Als Beispiel seien (Meth)acrylatcopolymerisate genannt, die unter Verwendung von (Meth)acrylamidmonomeren, wie z. B. CH₂=CH-COONH-CH₂OR, hergestellt wurden, und durch Erhitzen vernetzbar sind. Ein im Handel befindliches selbstvernetzendes Acrylharz ist beispielsweise der Carboset®-Typ 531 [GOODRICH].

Handelt es sich bei den Bindemittelpolymeren dagegen nicht um selbstvernetzende Typen, enthalten die erfindungsgemässen Zusammensetzungen als weitere Komponente ein in Wasser lösliches oder dispergierbares Vernetzungsmittel als Härter, und zwar ausgewählt aus der Gruppe Epoxidharze, Melaminharze und blockierte Polyisocyanate. Weniger bevorzugt, jedoch grundsätzlich auch möglich ist die Verwendung von Gemischen der genannten Vernetzungsmittel.

Als Vernetzungsmittel kommen übliche Epoxidharze in Frage, beispielsweise auf Basis von Bisphenolen, z. B. Bisphenol A, Novolaken, Hydantoinen, Uracilen und Isocyanuraten. Es kann sich sowohl um Monomere als auch um vorreagierte Addukte mit Polyaminen, Polycarbonsäuren, Polyalkoholen oder Polyphenolen etc. handeln. Geeignete Epoxidharze sind in vielfacher Form kommerziell erhältlich, beispielsweise unter Bezeichnungen wie Araldit® [CIBA-GEIGY], DEN® [DOW] usw. Eine besonders bevorzugte Zusammensetzung enthält ein Epoxidharz, z. B. auf Novolakbasis, als einzigen thermischen Härter.

Erfindungsgemässe Zusammensetzungen können auch ein Melaminharz als thermischen Härter enthalten, insbesondere als einzigen thermischen Härter, wobei als Melaminharze wiederum Kondensationsprodukte aus Melamin und Formaldehyd bevorzugt sind. Diese können beispielsweise durch Reaktion mit Hydroxylgruppen am Bindemittelpolymeren eine dreidimensionale Vernetzung bewirken. Für die Erfindung geeignete Melaminharze sind z. B. unter der Bezeichnung Cymel® auch kommerziell erhältlich.

Für die Erfindung geeignete blockierte Polyisocyanate können sich z. B. von aliphatischen, cycloaliphatischen, aromatischen oder araliphatischen Verbindungen mit mindestens zwei Isocyanatgruppen herleiten. Dazu zählen z. B. 2,4-Diisocyanatotoluol sowie dessen technische Gemische mit 2,6-Diisocyanatotoluol, 2,6-Diisocyanatotoluol, 4,4'-Diisocyanatodiphenylmethan sowie technische Gemische verschiedener Diisocyanatodiphenylmethane (beispielsweise der 4,4'- und der 2,4'-lsomeren), N,N'-Di(4-methyl-3-isocyanatophenyl)-harnstoff, 1,6-Diisocyanatohexan und ähnliche. Sie können mit unterschiedlichen Resten verkappt sein. Als Verkappungskomponenten eignen sich z. B. β-Dicarbonylverbindungen, wie Malonester, Acetoessigester oder 2,4-Pentandion, oder Hydroxamsäureester, Triazole, Imidazole, Imidazolide, Tetrahydropyrimidine, Lactame, Oxime, Hydroxyimide, wie N-Succinimid, oder Phenole bzw. Thiophenole. Es können auch urethanisierte, carbodiimidisierte oder di- bzw. trimerisierte Polyisocyanate eingesetzt werden, z. B. urethanisiertes 4,4'-Diisocyanatodiphenylmethan, carbodiimidisiertes 4,4'-Diisocyanatodiphenylmethan das Uretdion des 2,4-Diisocyanatotoluols oder das Trimerisat des Diisocyanatotoluols. Die Deblockierungstemperatur der verkappten Polyisocyanate liegt günstigerweise zwischen 90 und 160°C, bevorzugt zwischen 110 und 140°C. Erfindungsgemäss geeignete Polyisocyanate sind auch kommerziell erhältlich, z. B. unter der Bezeichnung Desmodur® [BAYER].

Erfindungsgemässe Zusammensetzungen, die ein blockiertes Polyisocyanat insbesondere als einzigen thermischen Härter enthalten, stellen ebenfalls eine bevorzugte Ausführungsform dar.

Als Photoinitiatoren lassen sich übliche Initiatoren der radikalischen Photopolymerisation einsetzen. Gewünschtenfalls können zusätzlich Coinitiatoren eingesetzt werden. An sich könnten die Initiatoren auch in Mengen von mehr als 10 Gew.-% vorhanden sein, dies führt jedoch zu keinen besseren Ergebnissen. Geeignete Beispiele für Photoinitiatorsysteme sind aromatische Carbonylverbindungen, wie beispielsweise Benzoin, Benzoinalkylether, wie der Isopropyl- oder der n-Butylether, α-substituierte Acetophenone, insbesondere Benzilketale, wie Benzildimethylketal, oder α-halogensubstituierte Acetophenone, wie Trichlormethyl-p-tert.butylphenyl-keton oder Morpholino-methyl-phenyl-keton, oder Dialkoxyacetophenone, wie Diethoxyacetophenon, oder α-Hydroxyacetophenone, wie 1-Hydroxycyclohexylphenyl-keton; oder Benzophenone, wie Benzophenon oder Bis-(4-dimethylamino)-benzophenon; oder Metalloceninitiatoren, wie Titanoceninitiatoren, z. B. Bis-(π-methylcyclopentadienyl)-bis-(σ-pentafluorophenyl)-titan-IV; oder ein Stannan in Kombination mit einem photoreduzierbaren Farbstoff, beispielsweise Trimethyl-benzyl-stannan in Kombination mit Methylenblau oder Bengalrosa; oder ein Chinon oder ein Thioxanthon in Kombination mit einem Amin, das an einem α-C-Atom mindestens ein Wasserstoffatom aufweist, wie Anthrachinon, Benzochinon oder Thioxanthon in Kombination mit Bis-(4-Dimethylamino)-benzophenon oder Triethanolamin; oder ein Thioxanthon, beispielsweise ein alkyl- oder halogen-substituiertes Thioxanton, wie 2-Isopropylthioxanthon oder 2-Chlorthioxanthon; oder Acylphosphide.

Geeignete photopolymerisierbare Acrylat- bzw. Methacrylatmonomere und -oligomere sind dem Fachmann ebenfalls bekannt und z. B. in der EP-A- 115354 genannt, auf die hierzu verwiesen wird. Für erfindungsgemässe Zwecke pot geeignet sind z. B. Diethylenglycoldiacrylat, Trimethylolpropantriacrylat, Pentaerythrittriacrylat oder Epoxidacrylate, z. B. von Bisphenol A, Phenol- oder Cresolnovolaken, Urethanacrylate oder Polyesteracrylate. Die Epoxidacrylate können auch in üblicher Weise mit einem Carbonsäureanhydid modifiziert sein.

Selbstverständlich können die erfindungsgemässen Zusammensetzungen neben den bisher genannten weitere Komponenten enthalten, so etwa in Wasser lösliche Farbstoffe und/oder in Wasser dispergierbare Pigmente, z. B. in einer Menge von 0,1 - 1 Gew.-%, oder auch sonstige für wässerige Lacke übliche Additive, gewöhnlich in Mengen zwischen 0,5 und 5 Gew.-%, z. B. Entschäumer, Haftvermittler, Fungizide oder Thixotropiermittel.

In manchen Fällen kann es auch günstig sein, wenn den Zusammensetzungen wasserverträgliche Füllstoffe zugesetzt sind, beispielsweise Talk, Bariumsulfat oder Quarz, mit denen z. B. Eigenschaften einer Beschichtung, wie deren Hitzebeständigkeit oder Isolationsfähigkeit gegen elektrische Ströme, verbessert oder die Klebrigkeit herabgesetzt werden können. Gegenstand der Erfindung ist daher auch eine spezielle Form der erfindungsgemässen Zusammensetzungen, die zusätzlich 10 - 35 Gew.-% wasserverträgliche Füllstoffe enthält.

Besonders bevorzugt sind die erfindungsgemässen Zusammensetzungen, bei denen die als Bindemittel fungierenden Polymere Acrylsäure- und/oder Methacrylsäure-Polymere bzw. -Copolymere und/oder Carboxylgruppen enthaltende Acrylat- und/oder Methacrylat-Polymere bzw. -Copolymere sind, bei denen jeweils Carboxylgruppen mit Ammoniak und/oder Aminen in einem solchen Ausmass umgesetzt sind, dass eine Wasserlöslichkeit der Polymere bzw. Copolymere gegeben ist, wobei die Amine so gewählt sind, dass sie sich zumindest bei Temperaturen, die zur thermischen Härtung der Polymere in der Zusammensetzung geeignet sind, i. w. aus einem aus der Zusammensetzung sich bildenden und/oder gebildeten Film verflüchtigen.

Ammoniak stellt eines der besonders geeigneten Neutralisationsmittel für die Umsetzung mit den Carboxylgruppen der Bindemittelpolymeren, insbesondere des letztgenannten Typs dar. Er hat bereits bei niederen Temperaturen einen relativ hohen Dampfdruck und kann sich besonders leicht aus einem Film verflüchtigen, der sich aus einer solchen erfindungsgemässen Zusammensetzung bildet. Im allgemeinen wird er bereits nach dem Trocknungsvorgang, der zur Entfernung des Wassers aus der applizierten Zusammensetzung notwendig ist, vollständig aus der Schicht verschwunden sein. Folglich hat die Erfindung auch eine strahlungsempfindliche Zusammensetzung mit einem Bindemittel aus Maleinsäureanhydrid/Vinylether-Copolymeren, Maleinsäureanhydrid/Styrol-Copolymeren und insbesondere aus Acrylsäure- und/oder Methacrylsäure-Polymeren bzw. -Copolymeren und/oder Carboxylgruppen enthaltenden Acrylat- und/oder Methacrylat-Polymeren bzw. -Copolymeren, wie oben beschrieben, zum Gegenstand, bei der die Carboxylgruppen mit Ammoniak umgesetzt sind.

Für die Umsetzung der Carboxylgruppen an den genannten Polymeren sind auch eine grosse Zahl von Aminen geeignet. In Frage kommen alle Arten von Aminen, wie primäre, sekundäre und tertiäre Amine, ebenso wie Heterocyclen mit Aminstickstoff. Ihre Auswahl wird lediglich dadurch eingeschränkt, dass die mit den Aminen umgesetzte Carboxylgruppen enthaltenden Polymere wasserlöslich sein sollen. Daher sollten die an den Aminstickstoff gebundenen organischen Reste bevorzugt nur relativ wenige Kohlenstoffatome enthalten. Bevorzugt weisen die organischen Reste der Amine Substituenten auf, die die Löslichkeit in Wasser förden, z. B. Hydroxylgruppen. Geeignete Amine sind beispielsweise niedere Alkylamine wie Monomethyl-, Dimethyl- und Trimethylamin, entsprechende reine Ethyl-, Propyl, Butylamine ebenso wie die genannten Reste enthaltende gemischte Amine. Gut geeignete Amintypen sind auch Alkanolamine, wie Ethanolamin, Dimethylethanolamin, Diethanolamin, Triethanolamin, oder 2-Amino-2-methyl-1,3-propandiol. Auch aromatische Amine, z. B. Anilin, können in Frage kommen. Als Beispiel für einen Aminstickstoff enthaltenden Heterocyclus sei Morpholin genannt.

Die erfindungsgemäss geeigneten Amine kann man weiterhin aufgrund ihrer Flüchtigkeit und ihres Siedepunktes in zwei Gruppen einteilen. Die erste Gruppe umfasst die Amine, die im Vergleich zu Wasser relativ flüchtig sind, z. B. solche, die bei gleicher Temperatur eine niedrigere Verdunstungszahl bzw. einen höheren Dampfdruck als Wasser aufweisen. Im allgemeinen wird es sich hierbei um Amine mit Siedepunkten unterhalb etwa 80°C handeln. Die zweite Gruppe umfasst die Amine, die weniger flüchtig sind als Wasser mit Siedepunkten im allgemeinen über 100°C. Beispiele sind Dimethylethanolamin, Diethanolamin, Triethanolamin oder 2-Amino-2-methyl- 1,3-propandiol.

Bei Zusammensetzungen, basierend auf Aminen der ersten Gruppe, kann die Trocknung der applizierten Zusammensetzung bzw. die Bildung eines Films aus der Zusammensetzung bei Temperaturen erfolgen, bei denen sich die entstandenen Aminiumcarboxylatgruppen des Bindemittelpolymeren bereits wieder zersetzen und sich das freie Amin bereits im wesentlichen aus der trocknenden Zusammensetzung verflüchtigt, wie dies zuvor für Ammoniak beschrieben wurde. Aufgrund der rückgebildeten freien Carboxylgruppen am Bindemittel sind diese Zusammensetzungen in wässrigem Alkali löslich. Spezielle erfindungsgemässe Zusammensetzungen sind demnach die oben beschriebenen, bei denen die Carboxylgruppen mit Aminen umgesetzt sind, die so gewählt sind, dass sie sich zumindest bei der Temperatur i. w. schon wieder verflüchtigen, die für die Bildung eines Films der strahlungsempfindlichen Zusammensetzung aus der Photopolymerlösung angewendet wird.

Die Aminiumcarboxylatgruppen am Bindemittel derjenigen erfindungsgemässen Zusammensetzungen, die auf weniger flüchtigen Aminen basieren, zersetzen sich hingegen auch bei den Temperaturen, wie sie zur Trocknung der Zusammensetzungen vorteilhaft sind, höchstens in geringem Masse. Auf Grund der in solchen Filmen daher noch vorhandenen grossen Zahl ionischer bzw. stark polarer Aminiumcarboxylatreste sind diese Filme in Wasser löslich, was vielfach von Vorteil sein kann. Die Erfindung betrifft daher auch Zusammensetzungen der oben beschriebenen Art, bei denen die Carboxylgruppen mit Aminen umgesetzt sind, die so gewählt sind, dass sie sich i. w. erst bei einer Temperatur wieder verflüchtigen, die oberhalb der Temperatur liegt, die für die Bildung eines Films der strahlenempfindlichen Zusammensetzung aus der Polymerlösung angewendet wird.

Selbstverständlich wäre es aber auch möglich, wasserlösliche Filme aus Zusammensetzungen, basierend auf auf Ammoniak oder den relativ flüchtigen Aminen der ersten Gruppe zu erhalten, wenn entsprechend schonende Trocknungsverfahren eingesetzt würden, bei denen sich Aminiumcarboxylatreste nicht zersetzen können.

Zur Herstellung erfindungsgemässer Zusammensetzungen hat sich das nachfolgend beschriebene Verfahren besonders bewährt und bildet daher ebenfalls einen Gegenstand der Erfindung. Bei diesem Verfahren werden, falls erforderlich, zunächst die Acrylat-und/oder Methacrylat-Monomeren und/oder Oligomeren durch Erwärmen in einen fliessfähigen Zustand überführt und die Photoinitiatoren darin gelöst. Gegebenenfalls können hier auch Coinitiatoren zugegeben werden. Zu dieser Lösung gibt man dann unter Rühren die Bindemittelpolymeren in Form einer wässerigen Lösung Danach können gegebenenfalls noch wässerige Lösungen bzw. Dispersionen weiterer gewünschter Komponenten zugegeben werden.

Die erfindungsgemässen Zusammensetzungen eignen sich besonders zur Herstellung von Beschichtungen auf Substraten aller Art, z. B. Holz, Textilien, Papier, Keramik, Glas, Kunststoffen,wie Polyester, Polyolefinen, Celluloseacetat oder Epoxidharzen, insbesondere glasfaserverstärkten Epoxidharzen, sowie Metallen, wie Al, Cu, Ni, Fe, Zn, Mg oder Co, und Halbleitermaterialien, wie Si, GaAs oder Ge, und Isolatormaterialien, wie Si₃N₄ oder SiO₂, bei denen durch Belichtung eine Abbildung oder insbesondere eine Schutzschicht aufgebracht werden soll.

Die Erfindung betrifft daher auch ein Verfahren zur Erzeugung einer Beschichtung, das die folgenden Verfahrensschritte enthält:
das Aufbringen einer strahlungsempfindlichen Zusammensetzung, wie sie oben beschrieben wurde, auf einem Substrat,
die Entfernung des Wassers aus der aufgetragenen Zusammensetzung unter Bildung eines Films der strahlungsempfindlichen Zusammensetzung auf dem Substrat,
die Belichtung des beschichteten Substrats mit aktinischer Strahlung in einem gewünschten Muster, die Entfernung
der nicht belichteten Stellen der Beschichtung mit Hilfe einer wässerigen oder alkalisch-wässerigen Lösung unter Freilegung des Substrats und
eine thermische Härtung und gegebenenfalls UV-Härtung der auf dem Substrat verbliebenen Beschichtung.

Die Herstellung der beschichteten Substrate kann mittels an sich bekannter Beschichtungsverfahren erfolgen, mit denen eine Beschichtung gleichförmig aufgebracht werden kann. Beispiele für solche Beschichtungsverfahren sind Aufschleudern, Aufpinseln, Aufsprühen, z. B. elektrostatisches Aufsprühen, Reverse-Rollbeschichtung,

Tauch- und Rakelbeschichtung und das Vorhanggiessverfahren. Für das Vorhanggiessverfahren sind erfindungsgemässe Zusammensetzungen besonders gut geeignet.

Die Auftragsmenge (Schichtdicke) und die Art des Substrates (Schichtträger) sind abhängig vom gewünschten Applikationsgebiet. Die erfindungsgemässen Zusammensetzungen können in relativ dünnen Schichten aufgebracht werden und bieten eine gute Auflösung. Sie eignen sich bei entsprechend gewählter Strahlenquelle und strahlungsempfindlicher Komponente für alle üblichen Anwendungsgebiete, wo die Erzeugung von strukturierten Bildern erwünscht ist.

Erfindungsgemässe Beschichtungen zeigen auch eine ausgezeichnete thermische Widerstandsfähigkeit, wenn sie mit heissen flüssigen Metallen und/oder Legierungen in Kontakt gebracht werden, wie beispielsweise mit einem Lötbad, das gewöhnlich eine Temperatur im Bereich von etwa 270°C aufweist. Diese Verwendung erfindungsgemäss hergestellter Beschichtungen gehört daher ebenfalls zum Gegenstand der Erfindung, ebenso wie die Verwendung der beschriebenen Zusammensetzungen als photostrukturierbarer Lötstoppresist bei der Herstellung von Leiterplatten, die ganz besonders bevorzugt wird.

Nach dem Beschichten wird das in den Zusammensetzungen enthältene Wasser üblicherweise durch Trocknen entfernt, und es resultiert eine amorphe Schicht des Resist auf dem Substrat, deren Dicke nach dem Trocknen vorzugsweise 5 - 150 µm beträgt. Die Temperaturen beim Trocknen liegen gewöhnlich unterhalb der Temperatur, bei der die thermische Vernetzung des Bindemittels in der Beschichtung abläuft, bevorzugt unterhalb 100 °C, z. B. bei etwa 70 - 80°C. Gegebenenfalls kann die Trocknung auch unter Vakuum durchgeführt werden, und selbstverständlich muss das Wasser auch nicht thermisch entfernt werden, sondern es kann z. B. auch durch Anlegen eines Vakuums allein getrocknet werden.

Wie oben bereits erläutert wurde, können sich bei Verwendung von Maleinsäureanhydrid/Vinylether-Copolymeren, Maleinsäureanhydrid/Styrol-Copolymeren und Acrylsäure- und Methacrylsäure-Polymeren bzw. Copolymeren sowie Carboxylgruppen enthaltenden Acrylat- und Methacrylat-Polymeren bzw. -Copolymeren als Bindemittel je nach Art des zur Neutralisation der freien Carboxylgruppen des Polymers verwendeten Agens die gebildeten Ammonium- bzw.

Aminiumcarboxylatgruppen während des Trocknungsvorgangs zersetzen, und der Ammoniak bzw. das Amin kann aus der Beschichtung ausdiffundieren und sich verflüchtigen. Je nach dem Verhalten des Neutralisationsagens wird eine andersartige Schicht erhalten. Zersetzen sich die Aminiumcarboxylatgruppen, ist sie in wässrigen Alkalien aber nicht in Wasser löslich, zersetzen sie sich dagegen nicht, können die Beschichtungen sogar in reinem Wasser gelöst werden.

Die strahlenempfindliche Schicht wird anschliessend in an sich bekannter Weise einer Strahlung ausgesetzt, um die Acrylat- und/oder Methacrylatmonomere und/oder entsprechende Oligomere zu photopolymerisieren. Dies erfolgt im allgemeinen bildmässig. An den belichteten Stellen stellt sich dabei infolge der Photopolymerisation der genannten Komponenten eine Verringerung der Löslichkeit gegenüber den unbelichteten Stellen ein, so dass eine Differenzierung der Oberfläche möglich wird.

Die Belichtung der erfindungsgemässen Zusammensetzungen erfolgt mit aktinischer Strahlung. Dabei handelt es sich in der Regel um UV- und/oder VIS-Strahlung, bevorzugt der Wellenlänge zwischen ca. 220 und 550 nm, speziell zwischen 220 - 450 nm. Zur Bestrahlung können alle an sich bekannten Strahlungsquellen eingesetzt werden, beispielsweise Quecksilberhochdrucklampen oder UV-/VIS-Laser. Die Verfahrensparameter, wie z. B. Bestrahlungsdauer und Abstand von Strahlungsquelle und strahlungsempfindlicher Schicht, werden im allgemeinen von der Art der strahlungsempfindlichen Zusammensetzung und von den gewünschten Eigenschaften des Überzugs abhängen und können vom Fachmann mit wenigen Routineversuchen festgelegt werden. Die bildmässige Belichtung kann z. B. durch eine Photomaske erfolgen oder durch direktes Schreiben eines Laserstrahls auf der strahlungsempfindlichen Schicht.

Nach der Belichtung erfolgt die Entwicklung. Durch die Einwirkung einer Entwicklerlösung können die unbelichteten Stellen des Photoresist entfernt werden. Als Entwickler für erfindungsgemäss verarbeitete Schichten sind vor allem wässerige Lösungen gut geeignet, die bei erfindungsgemässer Verwendung von (Meth)acrylatbindemitteln alkalisch sein müssen, wenn sich während der Trocknung bereits wieder viele freie Carboxylgruppen in der Beschichtung gebildet haben. Allerdings könnten auch Entwickler auf Basis organischer Lösungsmittel verwendet werden, z. B. Butyldiglycol. Da die Entwicklung im allgemeinen in einem geschlossenen Tank erfolgt, besteht hierbei nur eine geringe Gefahr von Lösungsmittelemissionen.

Nach der Belichtung und Entwicklung wird die Beschichtung noch einer thermischen Nachbehandlung oder Härtung unterworfen. Dazu wird auf eine Temperatur erhitzt, bei der die Vernetzung des Bindemittelpolymeren abläuft. Die dazu nötige Temperatur liegt gewöhnlich oberhalb von 100°C, z. B. im Bereich von 120 - 180°C, vorzugsweise von 120 - 150°C. In manchen Fällen kann es auch günstig sein, noch eine Härtung mit UV-Strahlung durchzuführen, die zu einer noch vollständigeren Polymerisation der (Meth)acrylatmonomeren bzw. -oligomeren führen kann. Dies kann beispielsweise gleichzeitig mit der thermischen Härtung geschehen.

Die Erfindung betrifft schliesslich noch zwei spezielle Ausführungsformen des vorgenannten Verfahrens unter Verwendung von strahlungsempfindlichen Lösungen auf Basis von Maleinsäureanhydrid/Vinylether-Copolymeren, Maleinsäureanhydrid/Styrol-Copolymeren und insbesondere auf Basis von Acrylsäure- und Methacrylsäure-Polymeren bzw. -Copolymeren sowie Carboxylgruppen enthaltende Acrylat- und Methacrylat-Polymeren bzw. -Copolymeren, bei denen jeweils Carboxylgruppen mit Aminen umgesetzt sind.

Bei einer Ausführungsform wird eine strahlungsempfindliche Zusammensetzung auf das Substrat aufgetragen, die unter Verwendung von Ammoniak oder eines Amins bereitet ist, das flüchtiger ist als Wasser. Die Bildung des Films der strahlungsempfindlichen Zusammensetzung erfolgt durch Erhitzen auf eine Temperatur, bei der sich der Ammoniak und/oder das Amin i. w. verflüchtigen, und die Entfernung der nicht belichteten Stellen der Beschichtung erfolgt mit Hilfe einer wässerig-alkalischen Lösung. Geeignet sind z. B. Alkalimetallcarbonatentwickler oder Niedrigalkylammoniumhydroxidlösungen, sogenannte metallfreie Entwickler, in einer Konzentration von z. B. 1 %.

Bei der zweiten speziellen Ausführungsform wird eine strahlungsempfindliche Zusammensetzung auf das Substrat aufgetragen, die unter Verwendung eines Amins bereitet ist, das weniger flüchtig ist als Wasser, wie dies oben näher erläutert wurde, die Entfernung der nicht belichteten Stellen der Beschichtung erfolgt mit Hilfe von Wasser und erst die Härtung wird bei einer Temperatur durchgeführt, die hoch genug ist, um das Amin i. w. zu verflüchtigen.

Überraschenderweise hat sich weiterhin gezeigt, dass Beschichtungen aus erfindungsgemässen Zusammensetzungen auf manchen Substraten, z.B. auf üblichen Leiterplattenlaminaten, dann besonders gute Qualität zeigen, wenn das Substrat zuvor mit Wasser leicht befeuchtet wurde, wie dies z. B. mit Hilfe eines Schwammes oder technisch mit Hilfe einer Gummiwalze möglich ist. Auf diese Weise kann z. B. ein besonders gleichmässiger Verlauf und eine äusserst geringe Tendenz zur Blasenbildung beim Trocknen erreicht werden. Bei einer besonders günstigen Ausführungsform des oben beschriebenen Verfahrens zur Erzeugung einer Beschichtung wird daher das Substrat vor dem Auftragen der Beschichtung befeuchtet.

Beispiel 1: Eine strahlungsempfindliche, strukturierbare Zusammensetzung wird durch Mischen folgender Komponenten hergestellt:

(Irgacure® 907 entspricht: 2-Methyl-1 -[4-(methylthio)phenyl]-2-morpholinopropanon-1; Byk®-Entschäumer [BYKMALLINCKRODT] sind Produkte auf Basis von Mineralölen mit Zusätzen wie Alkoholen, Metallseifen oder Emulgatoren)

| | |
|---|---|
| Bindemittel Carboset®525 (Polyacrylsäureharz, mit Ammoniak umgesetzt und in Wasser gelöst) | 14 Gew.-% |
| Trimethylolpropantriacrylat | 11 Gew.-% |
| Irgacure®907 | 1 Gew.-% |
| 4,4 Bis(diethylamino)benzophenon | 0,11 Gew.-% |
| Mikronisiertes (Partikel < 5µm) Triglycidylisocyanurat PT 810®, im Bindemittel eindispergiert | 4 Gew.-% |
| Wasser | 60 Gew.-% |
| Pigment Mikrolith®Blau | 0,1 Gew.-% |
| Entschäumer Byk 035® | 0,04 Gew.-% |
| Mikronisiertes Talkum (Partikel < 5µm) | 9,75 Gew.-% |

Der Photoinitiator wird dabei in dem Trimethylolpropantriacrylatmonomeren gelöst und in die wässerige Lösung des Bindemittels einemulgiert, danach werden die anderen Komponenten unter Rühren zugegeben. Unter Gelblicht bringt man Lösung dieser Zusammensetzung auf eine gereinigte Leiterplatte auf. Man trocknet 10 min an der Luft und weitere 30 min bei 80°C. Danach wird durch eine Photomaske 20 s mit einer 5000 W Metallhalogen-Quecksilberdampflampe belichtet. Anschliessend wird mit 1 %-iger Natriumcarbonatlösung entwickelt, wobei sich die nicht belichteten Partien der Beschichtung lösen, und die entwickelte Leiterplatte eine Stunde lang auf eine Temperatur von 140°C erhitzt, um die Beschichtung nachzuhärten.

Die mit Flussmittel beschichtete Platte wird für 10 s in ein 270°C heisses Lötbad getaucht. Man erhält völlig zugelötete Lötaugen und es treten weder an der Laminatschicht noch an der Kupferschicht der Leiterplatte Schäden auf.

Die folgenden Zusammensetzungen werden, soweit nichts anderes vermerkt ist, wie in Beispiel 1 verarbeitet:

Beispiel 2: Es wird folgende Zusammensetzung verwendet:

| | |
|---|---|
| Bindemittel Carboset®XL 37 (Polyacrylsäureharz, mit Ammoniak umgesetzt und in Wasser gelöst) | 14 Gew.-% |
| Epoxyacrylat Chemlink® 3000 | 8 Gew.-% |
| Diethylenglycoldiacrylat | 3 Gew.-% |
| Irgacure®907 | 1 Gew.-% |
| 4,4-Bis(diethylamino)benzophenon | 0,11 Gew.-% |
| Mikronisiertes blockiertes Isocyanurat Desmodur®AP Stabil, im Bindemittel dispergiert | 8 Gew.-% |
| Wasser | 60 Gew. -% |
| Pigment Mikrolith®Blau | 0,1 Gew.-% |
| Entschäumer Byk 80® | 0,04 Gew.-% |
| Talk | 9,75 Gew.-% |
| Haftvermittler (Triazolderivate) | 0,1 Gew.-% |

Bei siebentägiger Lagerung in einer Klimakammer (Temperatur von 60°C, Luftfeuchtigkeit 92%) unter einer Spannung von 100V tritt keine Korrosion auf.

Beispiel 3: Es wird eine Zusammensetzung wie in Beispiel 1 verwendet, jedoch das Bindemittel mit Diethanolamin umgesetzt. Nach der Belichtung kann mit Wasser entwickelt werden.

Beispiel 4: Es wird folgende Zusammensetzung verwendet:

| | |
|---|---|
| Carboset®1387 (Polyacrylsäure-Styrol-Copolymer, mit Ammoniak umgesetzt und in Wasser gelöst) | 13 Gew.-% |
| Pentaerythrittriacrylat | 11 Gew.-% |
| Irgacure®907 | 1 Gew.-% |
| 4,4-Bis(diethylamino)benzophenon | 0,11 Gew.-% |
| Melaminharz Cymel® 300 | 8 Gew.-% |
| Paratoluolsulfonsäure, mit Ammoniak neutralisiert | 0,25 Gew.-% |
| Wasser | 60 Gew.-% |
| Pigment Mikrolith®Blau | 0,1 Gew.-% |
| Entschäumer Byk 035® | 0,04 Gew.-% |
| Talk | 5,5 Gew.-% |

Die Leiterplatte widersteht einem heissen Lötbad, ohne dass Defekte auftreten.

Beispiel 5: Es wird folgende Zusammensetzung verwendet:

| | |
|---|---|
| Carboset®531 (Polyacryl säurebindemittel, mit Ammoniak umgesetzt und in Wasser gelöst) | 14 Gew.-% |
| Pentaerythrittriacrylat | 11 Gew.-% |
| Irgacure®907 | 1,1 Gew.-% |
| 4,4-Bis(diethylamino)benzophenon | 0,11 Gew.-% |
| Mikronisiertes phenolverkapptes Isocyanat Desmodur® AP Stabil | 8 Gew.-% |
| Wasser | 60 Gew.-% |
| Pigment Mikrolith®Blau | 0,1 Gew.-% |
| Entschäumer Byk 035® | 0,1 Gew.-% |
| Talk | 5,29 Gew.-% |
| Thixotropiermittel Bentone® LD-2 | 0,8 Gew.-% |
| Haftvermittler (Triazolderivate) | 0,5 Gew.-% |

Im Unterschied zu Beispiel 1 wird die Leiterplatte durch Vorhanggiessen beschichtet und im Durchlaufofen getrocknet. Nach dem Trocknen ist sie klebfrei. Belichtung, Entwicklung und Nachhärtung werden wieder wie in Beispiel 1 durchgeführt. Die Haftung der Beschichtung auf dem Kupfer und dem Laminat der Leiterplatte nach DIN 53151 ist vor und nach einstündigem Kochen in Wasser gut (Gt0).

Beispiel 6: Es wird folgende Zusammensetzung verwendet:

| | |
|---|---|
| Carboset®531 (Polyacrylsäurebindemittel, mit Ammoniak umgesetzt und in Wasser gelöst) | 12 Gew.-% |
| CRAYNOR CN 112 C 60® (acrylierter Epoxyphenol-novolak, 60%ig in Trimethylolpropantriacrylat) | 16,4 Gew.-% |
| Irgacure®907 | 1,3 Gew.-% |
| 4,4-Bis(diethylamino)benzophenon | 0,1 Gew.-% |
| Mikronisiertes oximverkapptes Isocyanat IPDI 1358 B-100 (Deblockierung bei ca. 120 °C) | 3 Gew.-% |
| Wasser | 60 Gew.-% |
| Pigment Mikrolith®Blau | 0,06 Gew.-% |
| Pigment Mikrolith®Gelb | 0,04 Gew.-% |
| Entschäumer Byk 035® | 0,1 Gew.-% |
| Talk | 7 Gew.-% |

Die Verarbeitung erfolgt entsprechend Beispiel 1, jedoch wird die Leiterplatte nach dem Entwicklungsschritt einer Nachbelichtung (3000 mJ/cm²) zur vollständigen Vernetzung der Acrylatgruppen unterzogen und anschliessend 1 Stunde bei 140 °C ausgehärtet. Bei einem nachfolgenden Lötbadtest treten keine Defekte auf.

Beispiel 7: Es wird folgende Zusammensetzung verwendet:

| | |
|---|---|
| Carboset®531 (Polyacrylsäurebindemittel, mit Ammoniak umgesetzt und in Wasser gelöst) | 4,2 Gew.-% |
| Fester Epoxynovolak Quatrex®2410, acryliert, umgesetzt mit Bernsteinsäureanhydrid (Erweichungspunkt: ca. 80 °C, Epoxidäquivalentgew.: ca 190, 1 Säureäquiv. pro kg), mit Ammoniak neutralisiert und in Wasser gelöst | 14,7 Gew.-% |
| Trimethylolpropantriacrylat | 6,2 Gew.-% |
| Irgacure®907 | 1,5 Gew.-% |
| 4,4-Bis(diethylamino)benzophenon | 0,2 Gew.-% |
| Mikronisiertes oximverkapptes Isocyanat IPDI 1358 B-100 (Deblockierung bei ca. 120 °C) | 2,8 Gew.-% |
| Wasser | 58 Gew.-% |
| Pigment Mikrolith®Blau | 0,06 Gew.-% |
| Pigment Mikrolith®Gelb | 0,04 Gew.-% |
| Entschäumer Byk 035® | 0,1 Gew.-% |
| Talk | 12,2 Gew.-% |

Die Verarbeitung erfolgt entsprechend Beispiel 6. Bei einem nachfolgenden Lötbadtest treten keine Defekte auf.

Beispiel 8: Es wird folgende Zusammensetzung verwendet:

| | |
|---|---|
| Carboset®531 (Polyacrylsäurebindemittel, mit Ammoniak umgesetzt und in Wasser gelöst) | 5,7 Gew.-% |
| Fester Epoxynovolak ECN 1299, acryliert, umgesetzt mit Bernsteinsäureanhydrid (1,2 Säure-äquiv. pro kg), mit Ammoniak neutralisiert und in Wasser gelöst | 13,4 Gew.-% |
| Trimethylolpropantriacrylat | 7,3 Gew.-% |
| Irgacure®907 | 1,6 Gew.-% |
| 4,4-Bis(diethylamino)benzophenon | 0,3 Gew.-% |
| Mikronisiertes Epoxycresolnovolak ECN 1299 | 2,5 Gew.-% |
| Wasser | 59 Gew.-% |
| Pigment Mikrolith®Blau | 0,06 Gew.-% |
| Pigment Mikrolith®Gelb | 0,04 Gew.-% |
| Entschäumer Byk 035® | 0,1 Gew.-% |
| Talk | 10 Gew.-% |

Die Verarbeitung erfolgt entsprechend Beispiel 6. Die Haftung der Beschichtung auf dem Kupfer und dem Laminat der Leiterplatte nach DIN 53151 ist gut (Gt0).

Beispiel 9: Es wird folgende Zusammensetzung verwendet:

| | |
|---|---|
| Fester Epoxynovolak ECN 1280, acryliert, umgesetzt mit Bernsteinsäureanhydrid (1,7 Säureäquiv. pro kg), mit Ammoniak neutralisiert und in Wasser gelöst | 19,3 Gew.-% |
| Pentaerythrittriacrylat | 4,8 Gew.-% |
| Irgacure®907 | 1,2 Gew.-% |
| 4,4-Bis(diethylamino)benzophenon | 0,2 Gew.-% |
| Mikronisiertes oximverkapptes Isocyanat IPDI 1358 B-100 (Deblockierung bei ca. 120 °C) | 5,3 Gew.-% |
| Wasser | 58 Gew.-% |
| Pigment Mikrolith®Blau | 0,06 Gew.-% |
| Pigment Mikrolith®Gelb | 0,04 Gew.-% |
| Entschäumer Byk 035® | 0,1 Gew.-% |
| Talk | 11 Gew.-% |

Die Verarbeitung erfolgt entsprechend Beispiel 6. Bei einem nachfolgenden Lötbadtest treten keine Defekte auf.

## Patentansprüche

1. Strahlungsempfindliche Zusammensetzung auf Basis von Wasser als Lösungs- und/oder Dispersionsmittel für ihre Komponenten die sich zur Herstellung einer Lötstoppresistbeschichtung eignet, die mit Hilfe einer wässerigen oder einer alkalisch-wässerigen Lösung entwickelbar ist, und die mindestens 30 Gew.-% Wasser sowie zumindest die folgenden Bestandteile in den angegebenen Mengen enthält:
10 - 50 Gew.-% in Wasser lösliche feste, vernetzbare, filmbildende Polymere als Bindemittel,
4 - 50 Gew.-% in Wasser lösliche und/oder dispergierbare photopolymerisierbare Acrylat- und/oder Methacrylatmonomere und/oder entsprechende Oligomere,
0,1 - 10 Gew.-% in Wasser lösliche und/oder dispergierbare Photoinitiatorverbindungen für die photopolymerisierbaren Acrylat- und/oder Methacrylatmonomere und/oder entsprechenden Oligomere sowie,
falls das Bindemittel nichtselbstvernetzende Polymere enthält,
2,5 - 40 Gew.-% in Wasser lösliche und/oder dispergierbare Vemetzungsmittel für die Bindemittelpolymere als thermischen Härter, ausgewählt aus der Gruppe: Epoxidharze, Melaminharze und blockierte Polyisocyanate.

2. Zusammensetzung nach Anspruch 1 bei der die als Bindemittel fungierenden Polymere ausgewählt sind aus der Gruppe:
Polyvinylalkohol/Polyvinylacetat-Polymere bzw. Copolymere sowie
Maleinsäureanhydrid/Vinylether-Copolymere,
Maleinsäureanhydrid/Styrol-Copolymere und
Acrylsäure- und Methacrylsäure-Polymere bzw. Copolymere sowie Carboxylgruppen enthaltende Acrylat- und Methacrylat-Polymere bzw. -Copolymere,
und wobei, ausser bei den Polyvinylalkohol/Polyvinylacetat-Polymeren bzw. -Copolymeren, jeweils Carboxylgruppen mit Ammoniak und/oder Aminen in einem solchen Ausmass umgesetzt sind, dass eine Wasserlöslichkeit der Polymere bzw. Copolymere gegeben ist, wobei die Amine so gewählt sind, dass sie sich zumindest bei Temperaturen, die zur thermischen Härtung der Polymere in der Zusammensetzung geeignet sind, im wesentlichen (i. w.) aus einem aus der Zusammensetzung sich bildenden und/oder gebildeten Film verflüchtigen.

3. Zusammensetzung nach Anspruch 2, bei der die als Bindemittel fungierenden Polymere Acrylsäure- und/oder Methacrylsäure-Polymere bzw. Copolymere und/oder Carboxylgruppen enthaltende Acrylat-und/oder Methacrylat-Polymere bzw. -Copolymere sind, bei denen jeweils Carboxylgruppen mit Ammoniak und/oder Aminen in einem solchen Ausmass umgesetzt sind, dass eine Wasserlöslichkeit der Polymere bzw. Copolymere gegeben ist, wobei die Amine so gewählt sind, dass sie sich zumindest bei Temperaturen, die zur thermischen Härtung der Polymere in der Zusammensetzung geeignet sind, i. w. aus einem aus der Zusammensetzung sich bildenden und/oder gebildeten Film verflüchtigen.

4. Zusammensetzung nach Anspruch 2 oder insbesondere nach Anspruch 3, bei der die Carboxylgruppen mit Ammoniak umgesetzt sind.

5. Zusammensetzung nach Anspruch 2 oder insbesondere nach Anspruch 3, bei der die Carboxylgruppen mit Aminen umgesetzt sind, die so gewählt sind, dass sie sich zumindest bei der Temperatur i. w. schon wieder verflüchtigen, die für die Bildung eines Films der strahlungsempfindlichen Zusammensetzung aus der Photopolymerlösung angewendet wird.

6. Zusammensetzung nach Anspruch 2 oder insbesondere nach Anspruch 3, bei der die Carboxylgruppen mit Aminen umgesetzt sind, die so gewählt sind, dass sie sich i. w. erst bei einer Temperatur wieder verflüchtigen, die oberhalb der Temperatur liegt, die für die Bildung eines Films der strahlenempfindlichen Zusammensetzung aus der Polymerlösung angewendet wird.

7. Zusammensetzung nach einem mindestens einem der Ansprüche 1 bis 6, enthaltend ein Epoxidharz als einzigen thermischen Härter.

8. Zusammensetzung nach mindestens einem der Ansprüche 1 bis 6, enthaltend ein blockiertes Polyisocyanat als einzigen thermischen Härter.

9. Zusammensetzung nach mindestens einem der Ansprüche 1 bis 8, die zusätzlich 10 - 35 Gew.-% wasserverträgliche Füllstoffe enthält.

10. Verfahren zur Herstellung einer Zusammensetzung nach mindestens einem der Ansprüche 1 bis 9, bei dem man
die Acrylat-und/oder Methacrylat-Monomeren und/oder Oligomeren, falls erforderlich, durch Erwärmen in einen fliessfähigen Zustand überführt,
die Photoinitiatoren darin löst,
zu dieser Lösung unter Rühren die Bindemittelpolymeren in Form einer wässerigen Lösung gibt und
gegebenenfalls danach wässerige Lösungen bzw. Dispersionen weiterer gewünschter Komponenten zugibt.

11. Verfahren zur Erzeugung einer Beschichtung, enthaltend die folgenden Schritte:
Auftragen von strahlungsempfindlicher Zusammensetzung nach mindestens einem der Ansprüche 1 bis 9 auf einem Substrat,
Entfernung des Wassers aus der aufgetragenen Zusammensetzung unter Bildung eines Films der strahlungsempfindlichen Zusammensetzung auf dem Substrat,
Belichtung des beschichteten Substrats mit aktinischer Strahlung in einem gewünschten Muster,
Entfernung der nicht belichteten Stellen der Beschichtung mit Hilfe einer wässerigen oder alkalisch-wässerigen Lösung unter Freilegung des Substrats,
thermische Härtung und gegebenenfalls UV-Härtung der auf dem Substrat verbliebenen Beschichtung.

12. Verfahren nach Anspruch 11, wobei strahlungsempfindliche Zusammensetzung nach einem der Ansprüche 2 bis 5 auf das Substrat aufgetragen wird, die Bildung des Films der stahlungsempfindlichen Zusammensetzung durch Erhitzen auf eine Temperatur erfolgt, bei der sich der Ammoniak und/oder das Amin i. w. verflüchtigen und die Entfernung der nicht belichteten Stellen der Beschichtung mit Hilfe einer wässerig-alkalischen Lösung erfolgt.

13. Verfahren nach Anspruch 11, wobei strahlungsempfindliche Zusammensetzung nach Anspruch 6 auf das Substrat aufgetragen wird, die Entfernung der nicht belichteten Stellen der Beschichtung mit Hilfe von Wasser erfolgt und die Härtung bei einer Temperatur durchgeführt wird, die hoch genug ist, um das Amin i. w. zu verflüchtigen.

## Claims

1. A radiation-sensitive composition which is based on water as solvent and/or dispersant for the components thereof, which composition is suitable for the production of a solder resist coating which can be developed with the aid of an aqueous or an alkaline-aqueous solution, and which comprises at least 30% by weight of water, plus at least the following constituents in the indicated amounts:
10-50% by weight of water-soluble, solid, crosslinkable, film-forming polymers as binder,
4-50% by weight of water-soluble and/or water-dispersible photopolymerisable acrylate and/or methacrylate monomers and/or corresponding oligomers,
0.1-10% by weight of water-soluble and/or water-dispersible photoinitiator compounds for the photopolymerisable acrylate and/or methacrylate monomers and/or corresponding oligomers, and,
if the binder contains non-selfcrosslinking polymers,
2.5-40% by weight of water-soluble and/or water-dispersible crosslinking agents for the binder polymers as thermal hardener, selected from the group consisting of epoxy resins, melamine resins and blocked polyisocyanates.

2. A composition according to claim 1, wherein the polymers acting as binder are selected from the group consisting of polyvinyl alcohol/polyvinyl acetate polymers and copolymers, maleic anhydride/vinyl ether copolymers, maleic anhydride/styrene copolymers and acrylic acid and methacrylic acid polymers and copolymers, as well as carboxyl group-containing acrylate and methacrylate polymers and copolymers, and where, except in the case of polyvinyl alcohol/polyvinyl acetate polymers and copolymers, in each case carboxyl groups are reacted with ammonia and/or amines in an amount sufficient to ensure the water-solubility of said polymers and copolymers, the amines being chosen such that, at least at temperatures suitable for the thermal cure of the polymers in the composition, they will substantially volatilise from a film which forms or has formed from said composition.

3. A composition according to claim 2, wherein the polymers acting as binder are acrylic acid and/or methacrylic acid polymers and copolymers, and/or carboxyl group-containing acrylate and/or methacrylate polymers and copolymers, in which in each case carboxyl groups are reacted with ammonia and/or amines in an amount sufficient to ensure the water-solubility of said polymers and copolymers, the amines being chosen such that, at least at temperatures suitable for the thermal cure of the polymers in the composition, they will substantially volatilise from a film which forms or has formed from said composition.

4. A composition according to claim 2 or, in particular, claim 3, wherein the carboxyl groups are reacted with ammonia.

5. A composition according to claim 2 or, in particular, claim 3, wherein the carboxyl groups are reacted with amines which are chosen such that they substantially volatilise again at least at the temperature which is applied to form a film of the radiation-sensitive composition from the photopolymer solution.

6. A composition according to claim 2 or, in particular, claim 3, wherein the carboxyl groups are reacted with amines which are chosen such that they substantially volatilise again only at a temperature which is above the temperature which is applied to form a film of the radiation-sensitive composition from the polymer solution.

7. A composition according to at least one of claims 1 to 6 comprising an epoxy resin as sole thermal hardener.

8. A composition according to at least one of claims 1 to 6 comprising a blocked polyisocyanate as sole thermal hardener.

9. A composition according to at least one of claims 1 to 8, which additionally contains 10-35% by weight of water-compatible fillers.

10. A process for the preparation of a composition according to at least one of claims 1 to 9, which comprises converting the acrylate and/or methacrylate monomers and/or oligomers, if necessary, by heating into a flowable state and dissolving the photoinitiators therein, adding to this solution, with stirring, the binder polymers in the form of an aqueous solution or dispersion, and thereafter optionally adding aqueous solutions or dispersions of other desired components.

11. A process for the production of a coating, comprising the following steps:
applying radiation-sensitive composition according to at least one of claims 1 to 9 to a substrate,
removing water from the applied composition to form a film of the radiation-sensitive composition on the substrate,
exposing the coated substrate to actinic radiation in a desired pattern,
removing the unexposed areas of the coating with an aqueous or aqueous-alkaline solution to uncover the substrate,
subjecting the coating remaining on the substrate to a thermal cure and an optional UV cure.

12. A process according to claim 11, which comprises applying radiation-sensitive composition according to one of claims 2 to 5 to the substrate, forming the film of the radiation-sensitive composition by heating to a temperature at which the ammonia and/or the amine substantially volatilises, and removing the unexposed areas of the coating with an aqueous-alkaline solution.

13. A process according to claim 11, which comprises applying radiation-sensitive composition according to claim 6 to the substrate, removing the unexposed areas of the coating with water, and effecting the cure at a temperature which is sufficiently high to cause substantial volatilisation of the amine.

14. A process according to claim 11, wherein the substrate is moistened prior to application of the coating.

15. Use of a product obtainable using a process according to one of claims 11 to 13, where the product is brought into contact with a hot liquid metal and/or hot liquid alloy.

16. Use of a composition according to at least one of claims 1 to 9 as solder resist.

## Revendications

1. Composition sensible au rayonnement à base d'eau en tant que solvant et/ou agent dispersant pour ses composants qui convient pour l'obtention d'un revêtement de résist d'arrêt de brasage qui peut être développé à l'aide d'une solution aqueuse ou hydroalcaline, et qui contient au moins 30 % en poids d'eau, ainsi qu'au moins les constituants suivants, dans les quantités indiquées :
- de 10 à 50 % % en poids de polymères filmogènes, réticulables, solides, hydrosolubles en tant que liant,
- de 4 à 50 % en poids de monomères d'acrylates et/ou de méthacrylates et/ou d'oligomères correspondants, photopolymérisables, hydrosolubles et/ou dispersables dans l'eau,
- de 0,1 à 10 % en poids de composés photoamorceurs hydrosolubles et/ou dispersables dans l'eau pour les monomères d'acrylates et/ou méthacrylates et/ou des oligomères correspondants, photopolymérisables, ainsi que
dans le cas où le liant contient des polymères qui ne sont pas auto-réticulables,
- de 2,5 à 40 % en poids d'agent réticulant hydrosoluble et/ou dispersable dans l'eau pour les liants polymères en tant que durcisseurs thermiques, pris dans le groupe constitué de résines époxydes, de résines de mélamine et de polyisocyanates bloqués.

2. Composition selon la revendication 1, dans laquelle les polymères agissant comme liants sont pris dans le groupe :
des polymères, respectivement des copolymères de poly(alcool vinylique)/poly(acétate de vinyle), ainsi que des copolymères d'anhydride maléique/vinyléther,
des copolymères d'anhydride maléique/styrène, et
des copolymères, respectivement des polymères d'acide acrylique et d'acide méthacrylique, ainsi que des copolymères, respectivement des polymères d'acrylates et de méthacrylates contenant des groupes carboxyle,
et dans laquelle outre les copolymères, respectivement les polymères de poly(alcool vinylique)/poly(acétate de vinyle), les groupes carboxyle réagissent à chaque fois avec l'ammoniac et/ou l'amine dans une mesure telle que l'on obtienne une solubilité des polymères, respectivement des copolymères, en choisissant les amines de façon telle à ce qu'il s'échappent essentiellement par volatilisation du film en cours de formation et/ou formé à partir de la composition, au moins à des températures appropriées au durcissement thermique des polymères d'une composition.

3. Composition selon la revendication 2, dans laquelle les polymères qui agissent comme liants sont des copolymères, respectivement des polymères d'acide acrylique et/ou d'acide méthacrylique, et/ou des copolymères, respectivement des polymères d'acrylates et/ou de méthacrylates contenant des groupes carboxyle, dans lesquels à chaque fois les groupes carboxyle réagissent avec l'ammoniac et/ou les amines dans une mesure telle, que l'on obtienne l'hydrosolubilité des polymères, respectivement des copolymères, en choisissant les amines de façon telle à ce qu'elles se volatilisent essentiellement du film en cours de formation et/ou formé à partir de la composition, au moins à des températures appropriées au durcissement thermique des polymères dans la composition.

4. Composition selon la revendication 2, ou plus particulièrement selon la revendication 3, dans laquelle les groupes carboxyle ont réagi avec l'ammoniac.

5. Composition selon la revendication 2 ou plus particulièrement selon la revendication 3, dans laquelle les groupes carboxyle ont réagi avec des amines choisies de façon qu'elles ne se volatilisent essentiellement à nouveau qu'au moins à des températures utilisées pour la formation d'un film de la composition sensible au rayonnement à partir de la solution de polymère.

6. Composition selon la revendication 2 ou plus particulièrement selon la revendication 3, dans laquelle les groupes carboxyle ont réagi avec des amines, que l'on choisit de façon telle qu'elles ne se volatilisent essentiellement à nouveau qu'à des températures supérieures à la température que l'on applique pour la formation d'un film de la composition sensible au rayonnement à partir de la solution de polymère.

7. Composition selon au moins l'une des revendications 1 à 6, contenant une résine époxyde en tant que durcisseur thermique unique.

8. Composition selon au moins l'une des revendications 1 à 6, contenant un polyisocyanate bloqué en tant que durcisseur thermique unique.

9. Composition selon au moins l'une des revendications 1 à 8, qui contient de plus de 10 à 35 % en poids de charge compatible à l'eau.

10. Procédé pour la préparation d'une composition selon au moins l'une des revendications 1 à 9, dans lequel
- on transforme les oligomères et/ou les monomères d'acrylates et/ou de méthacrylates, si nécessaire par chauffage, dans un état coulable,
- on y dissout les photoamorceurs,
- on ajoute à cette solution, en agitant, les polymères liants sous la forme d'une solution aqueuse, et
- éventuellement on ajoute ensuite des solutions, respectivement des dispersions aqueuses d'autres composants voulus.

11. Procédé pour la préparation d'un revêtement contenant les étapes suivantes :
- application à un substrat de la composition sensible au rayonnement selon au moins l'une des revendications 1 à 9,
- élimination de l'eau de la composition appliquée en formant un film de la composition sensible au rayonnement sur le substrat,
- irradiation du substrat revêtu par un rayonnement actinique selon un modèle voulu,
- élimination des endroits non irradiés du revêtement à l'aide d'une solution aqueuse, ou aqueuse-alcaline, en dégageant le substrat,
- durcissement thermique et éventuellement durcissement par des rayons UV du revêtement restant sur le substrat.

12. Procédé selon la revendication 11, dans lequel on applique au substrat la composition sensible au rayonnement selon l'une des revendications 2 à 5, on forme le film de la composition sensible au rayonnement à une température à laquelle l'ammoniac et/ou l'amine se volatilisent essentiellement et on élimine les endroits non irradiés du revêtement à l'aide d'une solution aqueuse-alcaline.

13. Procédé selon la revendication 11, dans lequel on applique au substrat la composition sensible au rayonnement selon la revendication 6, élimination des endroits non irradiés du revêtement à l'aide de l'eau et durcissement à une température qui est suffisamment élevée pour volatiliser essentiellement l'amine.

14. Procédé selon la revendication 11, où on humidifie le substrat avant application du revêtement.

15. Utilisation d'un produit que l'on peut obtenir par utilisation d'un procédé selon l'une des revendications 11 à 13, dans lequel on met en contact le produit avec un métal liquide chaud et/ou un alliage liquide chaud.

16. Utilisation d'une composition selon au moins l'une des revendications 1 à 9 , en tant que résist d'arrêt de brasage.
